# EUROPÄISCHE PATENTSCHRIFT

(11) **EP 2 539 899 B1**
(45) Veröffentlichungstag und Bekanntmachung des Hinweises auf die Patenterteilung: **21.01.2015**
(21) Anmeldenummer: 11704425.5
(22) Anmeldetag: 28.01.2011
(51) Int. Cl.: G11C 29/52

(54) **VERFAHREN ZUR ÜBERPRÜFUNG DER FUNKTIONSFÄHIGKEIT EINES SPEICHERELEMENTS**
METHOD FOR CHECKING THE FUNCTIONALITY OF A MEMORY ELEMENT
PROCÉDÉ POUR CONTRÔLER LE BON FONCTIONNEMENT D'UN ÉLÉMENT DE MÉMOIRE

(30) Priorität: 24.02.2010 DE 102010002309
(43) Veröffentlichungstag der Anmeldung: 02.01.2013
(73) Patentinhaber: Endress+Hauser GmbH+Co. KG, 79689 Maulburg (DE)
(72) Erfinder: FERRARO, Franco, 79739 Schwörstadt (DE)
(74) Vertreter: Andres, Angelika Maria
(86) Internationale Anmeldenummer: PCT/EP2011/051230
(87) Internationale Veröffentlichungsnummer: WO 2011/104065

(56) Entgegenhaltungen:
- US-A- 5 461 588

## Beschreibung

Die vorliegende Erfindung betrifft ein Verfahren zur Überprüfung der Funktionsfähigkeit eines Speicherelements, mit einem Stapelspeicher, wobei der Stapelspeicher einen definierten Bereich innerhalb des Speicherelements belegt, und wobei ein Stapelspeicherzeiger definiert ist, welcher in Form einer Adresse eine Position des Stapelspeichers anzeigt, von welcher aktuell Daten entnommen oder an welche aktuell Daten geschrieben werden. Ein derartiges Verfahren kommt beispielsweise bei einem eigensicheren Messgerät zur Bestimmung und Überwachung von Prozessgrößen zum Einsatz. Bei dem Speicherelement handelt es sich um einen flüchtigen Speicher, wie beispielsweise ein RAM - Random Access Memory -, oder um einen nicht flüchtigen Speicher, beispielsweise ein EEPROM oder einen Flash-Speicher.

Aus dem Stand der Technik sind verschiedene Verfahren zur Überprüfung von elektronischen Datenspeichern bekannt. Die US5461588 offenbart ein Verfahren, bei dem der Inhalt eines zu testenden Speicherbereichs zwecks Datensicherung während des Tests zwischengespeichert wird und nach Testende wieder in den ursprünglichen Speicherbereich zurückgeschrieben wird._Ein gängiges Verfahren ist die zyklische Redundanzprüfung. Bei diesem Verfahren wird im einfachsten Fall jeweils für Datenblocks bestimmter Größe eine Signatur gebildet und dem Datenblock angehängt. Dasselbe Verfahren wird erneut auf den Datenblock inklusive der angehängten Signatur angewandt. Nach dieser Operation sollte das Ergebnis Null sein. Weicht es von Null ab, ist ein Fehler beim Speichern aufgetreten.

Ein derartiges Testverfahren kann jedoch nur angewendet werden, wenn sich der Inhalt der Datenblocks während des Tests nicht verändert. Da das Programm zur Durchführung eines solchen Tests meist modular aufgebaut ist und selbst Speicherplatz benötigt, ist es notwendig, den aktuell zum Speichern verwendeten Bereich vom Test auszunehmen. Dies ist relativ aufwendig, risikobehaftet und kostet Zeit bei der Durchführung des Testprogramms. Um die Funktionsfähigkeit des Gerätes, in welchem das Speicherelement angeordnet ist, nicht zu beeinträchtigen, sollte ein Testprogramm aber gerade so wenig Zeit wie möglich in Anspruch nehmen. Die Aufgabe der Erfindung besteht darin, ein Verfahren anzugeben, welches es ermöglicht, einen kompletten Bereich eines Speicherelements zusammenhängend mittels eines modular aufgebauten Programms auf Funktionsfähigkeit zu überprüfen. Die Aufgabe wird dadurch gelöst, dass im Speicherelement ein erster Abschnitt definierter Länge abgegrenzt und zur Speicherung mindestens einer Signatur verwendet wird, welche zur Überprüfung der Funktionsfähigkeit des Speicherelements relevante Daten enthält, dass im Speicherelement ein zweiter Abschnitt definierter Länge abgegrenzt und als Hilfsspeicher verwendet wird, wobei die Positionen des ersten Abschnitts und des zweiten Abschnitts derart gewählt werden, dass der erste und der zweite Abschnitt aneinander angrenzen und außerhalb eines zu überprüfenden Speicherbereichs angeordnet sind, dass der zu überprüfende Speicherbereich von einem modular aufgebauten Testprogramm überprüft wird, wobei vor dem Start des Testprogramms die aktuelle Adresse des Stapelspeicherzeigers gespeichert wird und dem Stapelspeicherzeiger eine Adresse zugewiesen wird, welche dem Hilfsspeicher zugeordnet ist, sodass während des Testprogramms der Hilfsspeicher als Arbeitsspeicher verwendet wird, und dass nach Beendigung des Testprogramms dem Stapelspeicherzeiger wieder die Adresse derjenigen Position zugewiesen wird, welche er vor dem Start des Testprogramms anzeigte.

Durch den zusätzlichen Hilfsspeicher wird es ermöglicht, dass während des Durchlaufs des Testprogramms nicht auf den Stapelspeicher - auch Stack genannt - zugegriffen werden muss, sodass sich dessen Zellen nicht verändern. Hierdurch kann das Testprogramm den gesamten Speicherbereich in einem Durchlauf testen, was eine Zeitersparnis mit sich bringt. Während der Testphase weicht das Programm auf den Hilfsspeicher aus, sodass der Stapelspeicher mit dem übrigen zu überprüfenden Speicherbereich durchgängig getestet werden kann. Der Hilfsspeicher ist bevorzugt ebenfalls ein Stapelspeicher nach dem first in - last out - Prinzip.

Bevorzugt werden drei Signaturen gebildet und abgespeichert. Die erste Signatur wird über den gesamten zu überprüfenden Speicherbereich gebildet und spiegelt den Zustand bei Beginn des Testprogramms wieder. Die zweite Signatur wird über denselben Bereich, jedoch ohne die aktuelle Testzelle gebildet. Die dritte Signatur ist eine veränderliche Signatur. Diese wird während des Tests einer Testzelle laufend neu berechnet und während des Tests der Testzelle mit der zweiten Signatur bzw. am Ende des Tests der Testzelle mit der ersten Signatur verglichen. Stimmen die jeweils miteinander verglichenen Signaturen überein, ist für die Testzelle kein Speicherfehler aufgetreten. Die Länge einer Signatur, d.h. die Anzahl der Bits, richtet sich nach der Größe des zu überprüfenden Speicherbereichs.
Das Testprogramm überprüft nach dem Start alle Testzellen hintereinander, sodass bei Beendigung des Testprogramms alle Testzellen überprüft sind, oder das Testprogramm wird für jede Testzelle neu gestartet, sodass zwischen der Überprüfung der einzelnen Testzellen ein bestimmtes Zeitintervall liegt, während welchem die dem Speicherelement zugedachten Funktionen ausgeführt werden. Ist das Speicherelement Teil der Elektronik eines Messgerätes, ist eine solche Funktion beispielsweise das Speichern von Messdaten.

In einer ersten Ausgestaltung der erfindungsgemäßen Lösung wird ein transparenter GALPAT - Galopping Pattern - als Testprogramm verwendet. Hierbei handelt es sich um ein Diagnoseverfahren, das während der Laufzeit des Geräts bzw. des normalen Betriebs des Speicherelements durchgeführt wird und bei welchem eine Sicherung des zu überprüfenden Speicherbereichs vor der Funktionsüberprüfung nicht erforderlich ist. Dieses Verfahren ist zwar relativ aufwendig, besitzt jedoch eine hohe Fehleraufdeckungswahrscheinlichkeit von über 99%. Dies ist beispielsweise erforderlich, wenn das Speicherelement Teil eines Gerätes ist, welches hohen Sicherheitsanforderungen zu genügen hat, z.B. SIL 3.

Gemäß einer weiteren Ausgestaltung des erfindungsgemäßen Verfahrens wird für den Fall, dass der erste Abschnitt - die Signatur - vor dem zweiten Abschnitt - dem Hilfsspeicher - liegt, der zweite Abschnitt von hinten beginnend beschrieben, sodass im Falle eines Überlaufs in den ersten Abschnitt hineingeschrieben wird. Mit anderen Worten besitzt der erste Abschnitt für die Signatur einen niederwertigeren Adressbereich als der zweite Abschnitt für den Hilfsspeicher und der Hilfsspeicher wird beginnend mit der höchstwertigen Adresse, die seinem Adressbereich zugeordnet ist, beschrieben. Findet ein Überlauf oder "Stackoverflow" statt, das heißt, reicht der für den Hilfsspeicher reservierte Speicherplatz nicht aus, so wird an die nächst niedrigere Adresse geschrieben. Da diese bereits mit einem Teil der Signatur beschrieben ist, wird hierdurch die Signatur verändert. Dies wird sofort als Fehler erkannt. Entsprechend wird für den Fall, dass der erste Abschnitt hinter dem zweiten Abschnitt angeordnet ist, der zweite Abschnitt von vorn beginnend beschrieben, sodass im Falle eines Überlaufs in den ersten Abschnitt hineingeschrieben wird.

Eine weitere Ausgestaltung der Erfindung sieht vor, dass die Größe des Hilfsspeichers wesentlich kleiner ist als die des Stapelspeichers. Der Hilfsspeicher wird nur während der Überprüfung des Speicherelements vom Testprogramm als Arbeitsspeicher verwendet. Daher reicht eine relativ geringe Größe bzw. eine geringe Speicherkapazität aus, sodass der verwendbare Speicherbereich nicht merklich kleiner wird.

Gemäß einer Ausgestaltung wird die Größe des Hilfsspeichers derart gewählt, dass er zwischen 5 und 10 Prozent der Größe des Stapelspeichers beträgt.

Eine weitere Ausgestaltung sieht vor, dass bei einem Speicherelement mit 1024 Byte Speichervolumen für die Signatur 6 Byte und für den Hilfsspeicher 14 Byte abgegrenzt werden. Der Speicherplatz, welcher durch den zusätzlichen Hilfsspeicher verloren geht, ist bei dieser Verteilung vernachlässigbar gering.

Eine bevorzugte Ausgestaltung sieht vor, dass die Funktionsfähigkeit eines RAMs - Random Access Memory - überprüft wird.

Bei einer weiteren Ausgestaltung wird die Funktionsfähigkeit des Hilfsspeichers und der Signatur vor Beginn des Testprogramms überprüft. Die Funktionsfähigkeit des Hilfsspeichers sowie der Signatur wird bevorzugt mit einem einfachen Testprogramm überprüft, welches weniger aufwendig ist als die Durchführung der Überprüfung des eigentlichen Speicherbereichs und eine akzeptable Aufdeckungsrate für Bitfehler aufweist. Auf diese Weise wird Zeit bei dem Test des Hilfsspeichers und der Signatur eingespart.

Bei einer bevorzugten Ausgestaltung wird bei Beendigung des Testprogramms überprüft, ob die aktuelle Position des Stapelspeicherzeigers im Hilfsspeicher mit der Anfangsposition bei Beginn des Testprogramms übereinstimmt. Diese Bedingung muss erfüllt sein, wenn es sich bei dem Hilfsspeicher um einen Stapelspeicher handelt. Das Testprogramm ist bevorzugt derart konzipiert, dass der Stapelspeicherzeiger beim Aufruf einer Funktion erhöht und danach wieder erniedrigt wird. Wird zusätzlicher Speicherplatz benötigt, wird der Stapelspeicherzeiger entsprechend erhöht, jedoch wieder zurückgesetzt, sobald die gespeicherten Daten wieder ausgelesen wurden. Hierdurch sind die Anfangsposition des Stapelspeicherzeigers bei Beginn des Testprogramms und die Endposition bei Beendigung des Testprogramms identisch. Bei einem Vergleich der Endposition mit der Anfangsposition kann aus einer Abweichung darauf geschlossen werden, dass das Testprogramm fehlerhaft abgelaufen ist.

Eine Ausgestaltung der Erfindung sieht vor, dass eine Programmlaufkontrolle durchgeführt wird, welche überprüft, ob der gesamte zu überprüfende Speicherbereich von dem Testprogramm überprüft wurde. Beispielsweise werden an bestimmten Stellen des Testprogramms Signaturen aufaddiert. Am Ende des Testprogramms muss diese Summe einem bestimmten Wert entsprechen. Weicht die Summe von diesem Wert ab, ist ein Fehler im Testprogramm aufgetreten und die Zellen des zu überprüfenden Speicherbereichs wurden nicht richtig oder nicht komplett überprüft. Es versteht sich von selbst, dass alternativ auch andere Programmlaufkontrollen durchgeführt werden können.
Die Erfindung wird anhand der nachfolgenden Figur näher erläutert.

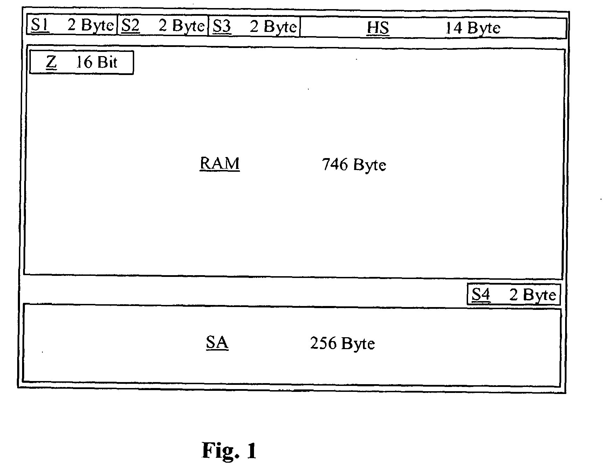

Fig. 1 zeigt eine schematische Darstellung der Aufteilung eines RAMs.

In Fig. 1 ist schematisch die Aufteilung eines Speicherelements in Abschnitte mit verschiedenen Funktionen am Beispiel eines RAMs dargestellt. Der mit RAM bezeichnete Abschnitt ist hierbei derjenige Teilbereich des RAMs, welchem keine separate Funktion zukommt und sozusagen den eigentlichen RAM-Bereich darstellt. Die Größe der jeweiligen Abschnitte ist hierbei lediglich beispielhaft zu verstehen, wobei die Verhältnisse der Größe der Abschnitte zueinander bei einer derartigen Ausgestaltung besonders vorteilhaft sind.

Der erste Abschnitt enthält drei Signaturen, welche von dem Testprogramm gebildet und abgespeichert werden: die beiden Referenzsignaturen S1 und S2, sowie die temporäre Signatur S3. Deren Bedeutung wird im Zusammenhang mit dem Testprogramm erläutert. Die drei Signaturen S1, S2, S3 sind jeweils gleich lang, wobei deren Länge von der Größe des zu überprüfenden RAM-Bereichs abhängt. So genügt beispielsweise eine 16-Bit Signatur für ein Speichervolumen von 4 Kilobyte, um eine ausreichend hohe Fehleraufdeckungsrate zu erreichen.

Das Testprogramm zur Überprüfung der Funktionsfähigkeit des RAMs ist entsprechend den jeweiligen Anforderungen an Fehleraufdeckungsrate und dem möglichen Zeitaufwand aus dem Stand der Technik zu wählen. Besonders geeignet sind Testprogramme, bei welchen eine Sicherung des Inhalts des RAMs nicht erforderlich ist. Um einen hohen Sicherheitsstandard zu erreichen ist insbesondere ein transparenter Galpat - Galopping Pattern - geeignet. Hierbei wird über den gesamten zu überprüfenden RAM-Bereich eine erste Referenzsignatur S1 gebildet. Für alle zu überprüfenden Zellen mit Ausnahme der aktuell zu überprüfenden Zelle, der Testzelle Z, wird eine zweite Signatur S2 gebildet. Dann wird der Inhalt der Testzelle invertiert und der Inhalt der restlichen Zellen überprüft, indem für diese eine temporäre Signatur S3 gebildet werden, welche mit der zweiten Signatur S2 übereinstimmen muss. Nach jedem Lesezugriff auf eine der übrigen Zellen wird der Inhalt der Testzelle Z überprüft. Nach einem kompletten Durchlauf wird die Testzelle Z wieder invertiert und dasselbe Verfahren auf die Testzelle Z mit wieder hergestelltem Inhalt angewendet. Dies wird für jede Zelle als Testzelle Z wiederholt. Die Größe der Testzelle Z richtet sich bevorzugt nach der Architektur des RAMs, d.h. bei einer 16-Bit Architektur ist die Testzelle ebenfalls 16 Bit groß. Hierdurch wird eine besonders effiziente Durchführung der Funktionsüberprüfung ermöglicht.

Neben dem beschriebenen transparenten Galpat eignen sich auch andere Testprogramme zur Funktionsüberprüfung des RAM. Beispielsweise kann eine Testzelle mit einem vorgegebenen Muster beschrieben werden und überprüft werden, ob der Inhalt nach zweimaligem Invertieren wieder hergestellt ist. Hierzu ist es allerdings erforderlich, den ursprünglichen Inhalt der Testzelle vor dem Start des Testprogramms zu sichern, was zu einem erhöhten Zeitaufwand für die Durchführung der Funktionsüberprüfung führt.

Der zweite Abschnitt auf dem RAM ist dem Hilfsspeicher HS ("Hilfsstack") zugeordnet. Dieser ersetzt den Stapelspeicher SA ("Stack") während des Durchlaufes des Testprogramms und gehört nicht zu dem zu überprüfenden RAM-Bereich. Bevorzugt wird der Hilfsspeicher HS aber von einem separaten Programm ebenfalls auf seine Funktionsfähigkeit überprüft.

An den Speicherplatz für den Hilfsspeicher HS schließen sich der eigentliche RAM-Bereich, sowie der Stapelspeicher SA an. Diese beiden Abschnitte bilden den zu überprüfenden RAM-Bereich. Zwischen dem RAM-Bereich und dem Stapelspeicher SA liegt eine weitere Signatur S4, welche sich während des normalen Betriebs bzw. Programmablaufs auf dem RAM nicht verändert. Die Signatur S4 wird regelmäßig auf Veränderungen überprüft. Veränderungen in der Signatur S4 treten dann auf, wenn der Speicherplatz im Stapelspeicher SA nicht ausreicht und daher die nächstliegende Zelle beschrieben wird. Da der Stapelspeicher SA von hinten nach vorn, d.h. mit der höchstwertigen Adresse beginnend, beschrieben wird, fällt diese in den Bereich der Signatur S4. Ein Overflow des Stapelspeichers SA kann somit detektiert werden.

Die zu überprüfenden Zellen müssen während des Durchlaufs des Testprogramms konstant sein. Um die Zellen des Stapelspeichers SA überprüfen zu können, verwendet das Testprogramm daher nicht den Stapelspeicher SA, sondern den Hilfsspeicher HS, welcher bevorzugt ebenfalls als Stapelspeicher ausgestaltet ist. Hierzu wird bei Beginn des Testprogramms der Stapelspeicherzeiger, auch Stackpointer genannt, der die Adresse anzeigt, von welcher aktuell Daten ausgelesen oder an welche aktuell Daten geschrieben werden, vom Stapelspeicher SA auf den Hilfsspeicher HS umgesetzt. Die Adresse im Stapelspeicher SA, welche der Stapelspeicherzeiger zu diesem Zeitpunkt anzeigt, wird im Stapelspeicher SA oder im Hilfsspeicher HS abgespeichert, sodass der Stapelspeicherzeiger bei Beendigung des Testprogramms wieder an diese Position zurückgesetzt werden kann. Der Stapelspeicherzeiger zeigt zu Beginn des Testprogramms auf die höchstwertigste Adresse des Hilfsspeichers HS. Während des Testprogramms werden dem Stapelspeicherzeiger entsprechend niedrigere Adressen zugewiesen. Sollte das Speichervolumen des Hilfsspeichers HS nicht ausreichen, wird somit in die temporäre Signatur S3 hineingeschrieben, was zu einer Fehlermeldung führt. Ein Overflow des Hilfsspeichers HS wird somit automatisch erkannt.

Bevorzugt werden die zu überprüfenden Zellen nicht unmittelbar hintereinander getestet, sondern es wird nur eine Testzelle pro Zeitintervall, z.B. pro Sekunde, getestet. Das Testprogramm wird also nach der Überprüfung einer Testzelle Z unterbrochen, bzw. das Testprogramm wird für jede Testzelle Z neu gestartet. Der Stapelspeicherzeiger wird entsprechend häufig zwischen dem Stapelspeicher SA und dem Hilfsspeicher HS umplatziert. Zwischen der Überprüfung der einzelnen Testzellen werden dem RAM zugedachte Funktionen ausgeführt, beispielsweise das Speichern von Messdaten. Die Unterbrechung bietet den Vorteil, dass weitere Funktionsüberprüfungen, welche die Zellen des Stapelspeichers verändern und daher nicht während der Durchführung des RAM-Tests stattfinden können, nicht für längere Zeit ausbleiben müssen. Ein Beispiel für solch eine weitere Funktionsüberprüfung ist die Überprüfung der Stacksignatur S4 zur Diagnose eines Stackoverflows. Durch den Wechsel zwischen Normalbetrieb und Speicherfunktionstest wird somit eine maximale Sicherheit bezüglich der Aufdeckung von Fehlern gewährleistet.

### Bezugszeichenliste

- S1: erste Referenzsignatur
- S2: zweite Referenzsignatur
- S3: temporäre Signatur
- S4: Signatur des Stapelspeichers
- HS: Hilfsspeicher/Hilfsstack
- SA: Stapelspeicher/Stack
- Z: Testzelle

## Patentansprüche

1. Verfahren zur Überprüfung der Funktionsfähigkeit eines Speicherelements mit einem Stapelspeicher (SA), wobei der Stapelspeicher einen definierten Bereich innerhalb des Speicherelements belegt, und wobei ein Stapelspeicherzeiger definiert ist, welcher in Form einer Adresse eine Position des Stapelspeichers (SA) anzeigt, von welcher aktuell Daten entnommen oder an welche aktuell Daten geschrieben werden,
**dadurch gekennzeichnet,**
**dass** im Speicherelement ein erster Abschnitt definierter Länge abgegrenzt und zur Speicherung mindestens einer Signatur (S1, S2, S3) verwendet wird, welche zur Überprüfung der Funktionsfähigkeit des Speicherelements relevante Daten enthält,
**dass** im Speicherelement ein zweiter Abschnitt definierter Länge abgegrenzt und als Hilfsspeicher (HS) verwendet wird,
wobei die Positionen des ersten Abschnitts und des zweiten Abschnitts derart gewählt werden, dass der erste und der zweite Abschnitt aneinander angrenzen und außerhalb eines zu überprüfenden Speicherbereichs angeordnet sind,
**dass** der zu überprüfende Speicherbereich von einem modular aufgebauten Testprogramm überprüft wird,
wobei vor dem Start des Testprogramms die aktuelle Adresse des Stapelspeicherzeigers gespeichert wird und dem Stapelspeicherzeiger eine Adresse zugewiesen wird, welche dem Hilfsspeicher (HS) zugeordnet ist, sodass während des Testprogramms der Hilfsspeicher (HS) als Arbeitsspeicher verwendet wird,
und **dass** nach Beendigung des Testprogramms dem Stapelspeicherzeiger wieder die Adresse derjenigen Position zugewiesen wird, welche er vor dem Start des Testprogramms anzeigte.

2. Verfahren nach Anspruch 1,
**dadurch gekennzeichnet,**
**dass** ein transparenter GALPAT - Galopping Pattern - als Testprogramm verwendet wird.

3. Verfahren nach Anspruch 1 oder 2,
**dadurch gekennzeichnet,**
**dass** für den Fall, dass der erste Abschnitt vor dem zweiten Abschnitt liegt, der zweite Abschnitt von hinten beginnend beschrieben wird, sodass im Falle eines Datenüberlaufs in den ersten Abschnitt hineingeschrieben wird.

4. Verfahren nach Anspruch 1 oder 2,
**dadurch gekennzeichnet,**
**dass** für den Fall, dass der erste Abschnitt hinter dem zweiten Abschnitt angeordnet ist, der zweite Abschnitt von vorn beginnend beschrieben wird, sodass im Falle eines Datenüberlaufs in den ersten Abschnitt hineingeschrieben wird.

5. Verfahren nach mindestens einem der vorangehenden Ansprüche,
**dadurch gekennzeichnet,**
**dass** die Größe des Hilfsspeichers (HS) wesentlich kleiner ist als die des Stapelspeichers (SA).

6. Verfahren nach Anspruch 5,
**dadurch gekennzeichnet,**
**dass** die Größe des Hilfsspeichers (HS) derart gewählt wird, dass er zwischen 5 und 10 Prozent des Stapelspeichers (SA) beträgt.

7. Verfahren nach mindestens einem der vorangehenden Ansprüche,
**dadurch gekennzeichnet,**
**dass** bei einem Speicherelement mit 1024 Byte Speichervolumen für die Signatur 6 Byte und für den Hilfsspeicher 14 Byte abgegrenzt werden.

8. Verfahren nach mindestens einem der vorangehenden Ansprüche,
**dadurch gekennzeichnet,**
**dass** die Funktionsfähigkeit eines RAMs - Random Access Memory - überprüft wird.

9. Verfahren nach mindestens einem der vorangehenden Ansprüche,
**dadurch gekennzeichnet,**
**dass** die Funktionsfähigkeit des Hilfsspeichers (HS) und der Signatur (S1, S2, S3) vor Beginn des Testprogramms überprüft werden.

10. Verfahren nach mindestens einem der vorangehenden Ansprüche,
**dadurch gekennzeichnet,**
**dass** bei Beendigung des Testprogramms überprüft wird, ob die aktuelle Position des Stapelspeicherzeigers im Hilfsspeicher mit der Anfangsposition bei Beginn des Testprogramms übereinstimmt.

11. Verfahren nach mindestens einem der vorangehenden Ansprüche,
**dadurch gekennzeichnet,**
**dass** eine Programmlaufkontrolle durchgeführt wird, welche überprüft, ob der gesamte zu überprüfende Speicherbereich von dem Testprogramm überprüft wurde.

## Claims

1. Method to check the functionality of a memory element with a stack memory (SA), wherein the stack memory occupies a defined area within the memory element, and wherein a stack memory index is defined which indicates, in the form of an address, a position of the stack memory (SA) from which data are currently taken or to which data are currently written,
**characterized in that**
a first section of defined length is demarcated in the memory element and is used to store at least a signature (S1, S2, S3) that contains data that are relevant for checking the functionality of the memory element,
**in that** a second section of defined length is demarcated in the memory element and is used as an auxiliary memory (HS),
wherein the positions of the first section and second section are selected in such a way that the first and second section are adjacent to one another and are arranged outside a memory area to be checked,
the memory area to be checked is checked by a test program with a modular design, wherein before the test program is started the current address of the stack memory index is saved and the stack memory index is assigned an address that is allocated to the auxiliary memory (HS), such that the auxiliary memory (HS) is used as a main memory during the test program,
and **in that** on completion of the test program the stack memory index is again assigned the address of the specific position which the index displayed before the test program commenced.

2. Method as claimed in Claim 1,
**characterized in that**
a transparent GALPAT - galloping pattern - is used as the test program.

3. Method as claimed in Claim 1 or 2,
**characterized in that**
in the event that the first section is upstream from the second section, the second section is written to starting from the end so that, in the event of data overrun, data are written to the first section.

4. Method as claimed in Claim 1 or 2,
**characterized in that**
in the event that the first section is downstream from the second section, the second section is written to starting from the start so that, in the event of data overrun, data are written to the first section.

5. Method as claimed in at least one of the previous claims,
**characterized in that**
the size of the auxiliary memory (HS) is significantly smaller than the size of the stack memory (SA).

6. Method as claimed in Claim 5,
**characterized in that**
the size of the auxiliary memory (HS) is selected in such a way that it is between 5 and 10 percent of the stack memory (SA).

7. Method as claimed in at least one of the previous claims,
**characterized in that**
for a memory element with a memory volume of 1024 bytes, 6 bytes are demarcated for the signature and 14 bytes for the auxiliary memory.

8. Method as claimed in at least one of the previous claims,
**characterized in that**
the functionality of a random access memory - RAM - is checked.

9. Method as claimed in at least one of the previous claims,
**characterized in that**
the functionality of the auxiliary memory (HS) and the signature (S1, S2, S3) are checked before the test program starts.

10. Method as claimed in at least one of the previous claims,
**characterized in that**
when the test program ends a check is run to determine whether the current position of the stack memory index in the auxiliary memory matches the initial position at the start of the test program.

11. Method as claimed in at least one of the previous claims,
**characterized in that**
a program run check is performed which checks whether the entire storage area to be checked was checked by the test program.

## Revendications

1. Procédé permettant de contrôler la capacité de fonctionnement d'un élément de mémoire comprenant une pile mémoire (SA), la pile mémoire (SA) occupant une zone définie dans l'élément de mémoire, et un indicateur de pile mémoire étant défini, qui indique sous forme d'adresse une position de la pile mémoire (SA) à partir de laquelle les données sont en train d'être extraites ou vers laquelle les données sont en train d'être écrites,
**caractérisé en ce**
**qu'**une première section d'une longueur définie est délimitée dans l'élément de mémoire et utilisée pour la mémorisation d'au moins une signature (S1, S2, S3), laquelle contient des données importantes pour le contrôle de la capacité de fonctionnement de l'élément de mémoire,
en ce qu'une deuxième section d'une longueur définie est délimitée dans l'élément de mémoire et utilisée en tant que mémoire auxiliaire (HS),
les positions de la première section et de la deuxième section étant choisies de telle sorte que la première et la deuxième section soient contiguës et disposées en dehors d'une zone de mémoire à contrôler,
en ce que la section de mémoire à contrôler est contrôlée par un programme de test de structure modulaire,
l'adresse actuelle de l'indicateur de pile mémoire étant enregistrée avant le début du programme de test et une adresse étant attribuée à l'indicateur de pile mémoire, laquelle adresse est affectée à la mémoire auxiliaire (HS), si bien que pendant le programme de test, la mémoire auxiliaire (HS) est utilisée en tant que mémoire de travail,
et en ce qu'au terme du programme de test, l'indicateur de pile mémoire se voit de nouveau affecter l'adresse de la position qu'il affichait avant le début du programme test.

2. Procédé selon la revendication 1,
**caractérisé en ce**
**qu'**est utilisé un algorithme GALPAT ("Galopping Pattern") transparent en tant que programme de test.

3. Procédé selon la revendication 1 ou 2,
**caractérisé en ce**
**que** pour le cas où la première section se situe avant la deuxième section, la deuxième section est écrite en commençant par la fin de la section, si bien qu'en cas de débordement des données, l'écriture des données se poursuit dans la première section.

4. Procédé selon la revendication 1 ou 2,
**caractérisé en ce**
**que** pour le cas où la première section se situe après la deuxième section, la deuxième section est écrite en commençant par la début de la section, si bien qu'en cas de débordement des données, l'écriture des données se poursuit dans la première section.

5. Procédé selon au moins l'une des revendications précédentes,
**caractérisé en ce**
**que** la taille de la mémoire auxiliaire (HS) est nettement inférieure à celle de la pile mémoire (SA).

6. Procédé selon la revendication 5,
**caractérisé en ce**
**que** la taille de la mémoire auxiliaire (HS) est choisie de telle sorte à ce qu'elle représente entre 5 et 10 pour-cent de la pile mémoire (SA).

7. Procédé selon au moins l'une des revendications précédentes,
**caractérisé en ce**
**que** dans le cas d'un élément de mémoire d'une capacité de 1024 octets, 6 octets sont délimités pour la signature et 14 octets pour la mémoire auxiliaire.

8. Procédé selon au moins l'une des revendications précédentes,
**caractérisé en ce**
**qu'**est contrôlée la capacité de fonctionnement d'une mémoire RAM ("Random Access Memory").

9. Procédé selon au moins l'une des revendications précédentes,
**caractérisé en ce**
**qu'**est contrôlée la capacité de fonctionnement de la mémoire auxiliaire (HS) et de la signature (S1, S2, S3) avant le début du programme de test.

10. Procédé selon au moins l'une des revendications précédentes,
**caractérisé en ce**
**que** lors de la fin du programme de test, on contrôle si la position actuelle de l'indicateur de pile mémoire au sein de la mémoire auxiliaire coïncide avec la position initiale au commencement du programme de test.

11. Procédé selon au moins l'une des revendications précédentes,
**caractérisé en ce**
**qu'**est réalisé un contrôle d'exécution du programme, lequel vérifie si la zone de mémoire complète à contrôler a été contrôlée par le programme de test.
